# EUROPÄISCHE PATENTSCHRIFT

(11) **EP 0 627 874 B1**
(45) Veröffentlichungstag und Bekanntmachung des Hinweises auf die Patenterteilung: **17.12.1997**
(21) Anmeldenummer: 94105677.2
(22) Anmeldetag: 13.04.1994
(51) Int. Cl.: H05K 3/40

(54) **Verfahren zur Durchkontaktierung von Leiterplatten**
Process for making through-hole connections in printed circuit boards
Procédé pour établir des connexions à trous traversants dans des panneaux à circuit imprimé

(30) Priorität: 04.06.1993 DE 4318604
(43) Veröffentlichungstag der Anmeldung: 07.12.1994
(73) Patentinhaber: THOMSON multimedia, 92648 Boulogne Cédex (FR)
(72) Erfinder: Funck, Eberhard, D-31139 Hildesheim (DE); Hauschild, Frank-Dieter, D-31135 Hildesheim (DE); Heyne, Michael, D-31139 Hildesheim (DE)
(74) Vertreter: Wördemann, Hermes, Dipl.-Ing.

(56) Entgegenhaltungen:
- EP-A- 0 194 247
- IBM TECHNICAL DISCLOSURE BULLETIN., Bd.33, Nr.5, Oktober 1990, NEW YORK US Seiten 104 - 108, XP000107397 'Screen mask for through-hole printing'
- DATABASE WPI Week 8541, Derwent Publications Ltd., London, GB; AN 85-252986 & JP-A-60 167 396 (HITACHI MAXELL) 30. August 1985
- ELEKTRONIK PRODUKTION UND PRüFTECHNIK (EPP), Dezember 1990 Seite 54 'Siebdruck statt Plattierung'

## Beschreibung

Die Erfindung betrifft ein Verfahren zur Durchkontaktierung von Leiterplatten nach dem Oberbegriff des Anspruchs 1.

Die Herstellung von elektrischen Verbindungen zwischen Leiterbahnen, die auf beiden Seiten einer Leiterplatte angeordnet sind, kann mittels einer Durchkontaktierung der Leiterplatte erfolgen.

Ein verfahren zur Durchkontaktierung von Leiterplatten gemäß dem Oberbegriff des Anspruchs 1 ist aus dem Dokument EP-A-0 194 247 bekannt.

Desweiteren ist ein Verfahren bekannt (N.N. Siebdruck statt Plattierung, EPP Dezember 1990, Seite 54), bei dem vorgesehene Durchkontaktierungslöcher einer Leiterplatte in einem Siebdruckvorgang mit Silberleitpaste ausgefüllt werden, welche auf beiden Seiten der Leiterplatte angeordnete Leiterbahnen miteinander verbindet. Zur Vermeidung von Rißbildungen, die bei den hierbei weitgehend massiv ausgebildeten Verbindungsleitern unter thermischen Belastungen auftreten können, sind Materialien mit sehr ähnlichen Ausdehnungskoeffizienten zwingend erforderlich. Zudem benötigen die aus Silberleitpaste gebildeten massiven Verbindungsleiter eine relativ lange Zeit zum Trocknen.

Der Erfindung liegt die Aufgabe zugrunde, ein Verfahren zur Durchkontaktierung von Leiterplatten anzugeben, welches eine kurze Trockenzeit für die Silberleitpasten-Verbindungsleiter erfordert und wenig aufwendige, zuverlässige elektrische Verbindungen ermöglicht.

Diese Aufgabe wird bei einem gattungsgemäßen Verfahren zur Durchkontaktierung von Leiterplatten erfindungsgemäß durch die im kennzeichnenden Teil des Anspruchs 1 angegebenen Maßnahmen gelöst.

Die mit der Erfindung erzielten Vorteile bestehen insbesondere darin, daß die nach ihr hergestellten Durchkontaktierungen auch unter thermischen Belastungen und bei Leiterplatten aus unterschiedlichen Materialien eine hohe Funktionssicherheit aufweisen. Zudem ermöglicht das Verfahren eine relativ rasche Weiterverarbeitung.

Mit dem Verfahren nach Anspruch 1 lassen sich bei einer einseitig mit Leiterbahnen versehenen Leiterplatte in vorteilhafter Weise, zusammen mit der Durchkontaktierung, die Leiterbahnen der anderen Leiterplattenseite mit Silberleitpaste drucken, und läßt sich die Dicke der Silberpastenschicht auf dem Drucksieb sehr gleichmäßig bestimmen, welches für die Gleichmäßigkeit der Durchkontaktierung über die gesamte Fläche der Leiterplatte von Bedeutung ist.

In der Zeichnung sind als Ausführungsbeispiel skizzierte Verfahrensschritte einer Durchkontaktierung einer beidseitig mit Leiterbahnen versehenen Leiterplatte dargestellt.

Es zeigen in geschnittener Seitenansicht:
- Fig. 1: einen Ausschnitt einer beidseitig mit Leiterbahnen und einer durchgehenden Bohrung versehenen Leiterplatte, über der ein mit einer Silberleitpastenschicht versehenes Drucksieb angeordnet ist,
- Fig. 2: die Leiterplatte mit aufliegendem Drucksieb,
- Fig. 3: die Bohrung vor der Beendigung einer Durchsaugphase,
- Fig. 4: die Bohrung nach dem Abstreifen der Silberleitpaste vom Drucksieb und
- Fig. 5: die Durchkontaktierung nach dem Abheben des Drucksiebes.

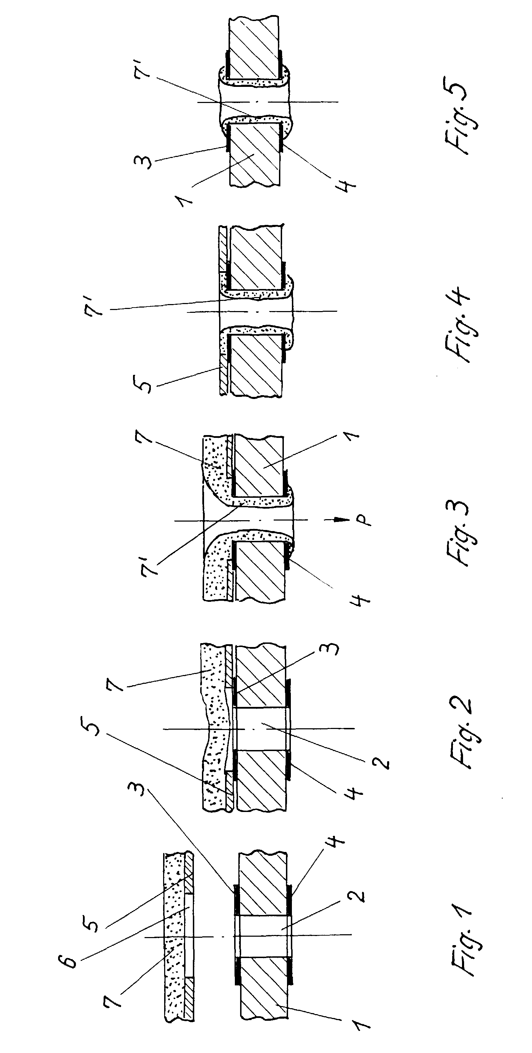

In einer an sich bekannten, nicht dargestellten Siebdruckmaschine wird eine auf ihrer Oberseite und Unterseite mit Leiterbahnen versehene Leiterplatte 1 waagerecht gehaltert. Die Leiterplatte 1 ist mit als Bohrung ausgebildeten Durchkontaktierungslöchern 2 versehen, die von in den Leiterbahnen angeordneten Lötaugen 3, 4 umschlossen sind. In einem vorgegebenen Abstand befindet sich über der Leiterplatte 1 ein Drucksieb 5, welches den Durchkontaktierungslöchern 2 zugeordnete Öffnungen 6 aufweist und auf dessen Oberfläche eine Schicht Silberleitpaste 7 mittels einer nicht dargestellten Rakel gleichmäßig aufgetragen wird (Fig. 1). Daraufhin wird das Drucksieb 5 auf die Leiterplatte 1 abgesenkt, so daß es auf dieser aufliegt (Fig. 2). Anschließend wird die Unterseite der Leiterplatte 1 einem Unterdruck p ausgesetzt, dessen Intensität und Wirkdauer derart bemessen ist, daß die Silberleitpaste 7 hohlzylinderförmige, an den Wandungen der Durchkontaktierungslöcher 2 anliegende, elektrische Leiter 7' bildet, welche die Innenränder der Lötaugen 3, 4 flanschartig umgreifen (Fig. 3). Daraufhin wird die überschüssige Silberleitpaste 7 mittels einer Rakel vom Drucksieb 5 abgestreift, wobei durch die Öffnungen 6 bedingte obere Flansche und ggf. auch Leiterbahnen gedruckt werden. Nach dem Abheben des Drucksiebes nehmen die von der Silberleitpaste gebildeten Leiter 7' die in der Fig. 5 dargestellte Form an.

Mittels einer Spezial-Rakel nach Patentanmeldung Az.: P 24 17 752.9 läßt sich in vorteilhafter Weise eine gleichmäßig hohe Silberleitpastenschicht auf dem Drucksieb erzeugen.

## Patentansprüche

1. Verfahren zur Durchkontaktierung von Leiterplatten, bei dem mittels eines Drucksiebes (5) in vorgesehene Durchkontaktierungslöcher (2) einer Leiterplatte (1) Leitpaste (7) eingebracht wird, welche auf beiden Seiten der Leiterplatte (1) angeordnete Leiterbahnen elektrisch leitend miteinander verbindet, wobei auf das Drucksieb (5), welches den Durchkontaktierungslöchern (2) und den diese umgebenden Lötungen (3,4) der Leiterplatte (1) zugeordnete Öffnungen (6) aufweist, eine Leitpaste (7) aufgebracht wird, wobei das Drucksieb (5) mit der Leiterplatte (1) zusammengebracht wird, wobei die Unterseite der Leiterplatte (1) einem Unterdruck (p) ausgesetzt wird, dessen Intensität und Zeitdauer so bemessen ist, daß die Leitpaste (7) hohlzylinderförmige, an den Wandungen der Durchkontaktierungslöcher (2) anliegende, elektrische Leiter (7') bildet, welche die Innenränder der Lötungen (3,4) flanschartig umgreifen, und wobei vor dem Abheben des Drucksiebes (5) von der Leiterplatte (1) die Leitpaste (7) mit einer Rakel vom Drucksieb abgestreift wird und die oberen Flanschdurchmesser der elektrischen Leiter (7') von den Durchmessern der den Durchkontaktierungslöchern zugeordneten Öffnungen (6) bestimmt werden, **dadurch gekennzeichnet**, daß als Lötungen (3,4) Lötaugen vorgesehen sind, daß als Leitpaste (7) Silberleitpaste verwandt wird, daß eine Schicht Silberleitpaste (7) gleichmäßiger Dicke auf das in einem vorgegebenen Abstand über der Leiterplatte 1 vorgesehene Drucksieb (5) aufgetragen wird und daß danach das mit der Silberleitpastenschicht versehene Drucksieb (5) durch absenken mit der Leiterplatte (1) zusammengebracht wird, so daß es auf dieser aufliegt und daß anschließend die Unterseite der Leiterplatte (1) dem Unterdruck (p) ausgesetzt wird.

## Claims

1. Method of producing through-contacts in printed circuit boards in which a conductive paste (7) is introduced into the holes (2) provided in a printed circuit board (1) for the through-contacts with the aid of a printing screen (5), said conductive paste (7) interconnecting the conductive tracks on the two sides of the printed circuit board (1) in an electrically conductive manner, wherein a conductive paste (7) is applied to the printing screen (5) which comprises openings (6) that are associated with the holes (2) for the through-contacts and the soldering points (3, 4) of the printed circuit board (1) surrounding them, wherein the printing screen (5) and the printed circuit board (1) are brought together, wherein the lower side of the printed circuit board (1) is subjected to a low pressure (p), the intensity and duration of which are regulated such that the conductive paste (7) forms hollow, cylindrical, electrically conductive paths (7') on the walls of the holes (2) for the through-contacts, said conductive paths (7') encompassing the inner edges of the soldering points (3, 4) in flange-like manner, and wherein the conductive paste (7) is stripped from the printing screen with a squeegee means before the printing screen (5) is lifted away from the printed circuit board (1) and the diameters of the upper flanges of the electrically conductive paths (7') are determined by the diameters of the openings (6) associated with the holes for the through-contacts, characterised in that solder pads are provided as the soldering points (3, 4), that a conductive silver paste is used as the conductive paste (7), that a layer of conductive silver paste (7) of uniform thickness is coated onto the printing screen (5) which is disposed at a predetermined distance above the printed circuit board (1) and that thereafter, the printing screen (5) together with its layer of conductive silver paste is placed in contact with the printed circuit board (1) by lowering it so that it lies thereupon and that the lower side of the printed circuit board (1) is then subjected to the low pressure (p).

## Revendications

1. Procédé de connexion transversale de cartes imprimées, dans lequel de la pâte conductrice (7) est intégrée dans des trous de connexion transversale (2) prévus sur une carte imprimée (1) à l'aide d'un tamis d'impression (5), où elle relie des pistes conductives disposées de part et d'autre de la carte imprimée (1) de manière à en assurer la conduction électrique, une pâte conductrice (7) étant appliquée sur le tamis d'impression (5), qui présente des ouvertures (6) affectées aux trous de connexion transversale (2) et aux soudures (3, 4) de la carte imprimée (1) les entourant, le tamis d'impression (5) étant mis au contact de la carte imprimée (1) et la face inférieure de la carte imprimée (1) étant exposée à une dépression (p), dont l'intensité et la durée sont calculées de manière à ce que la pâte conductrice (7) forme des conducteurs électriques (7') en forme de cylindres creux, collés aux parois des trous de connexion transversale (2), qui enserrent les bords intérieurs des soudures (3, 4) à l'instar de brides et où la pâte conductrice (7) est enlevée du tamis d'impression au moyen d'une raclette avant le retrait du tamis d'impression (5), les diamètres des brides supérieures des conducteurs électriques (7') étant déterminés par les diamètres des ouvertures (6) affectées aux trous de connexion transversale, caractérisé en ce que des pastilles de soudure sont prévues en guise de soudures (3, 4), que de la pâte conductrice en argent est utilisée comme pâte conductrice (7), qu'une couche de pâte conductrice en argent (7) d'épaisseur régulière est appliquée sur le tamis d'impression (5) prévu à une certaine distance au-dessus de la carte imprimée (1) et que le tamis d'impression (5) pourvu de la couche de pâte conductrice en argent est ensuite mis au contact de la carte imprimée (1) par abaissement, de manière à reposer sur celle-ci et que la face inférieure de la carte imprimée (1) est ensuite exposée à la dépression (p).
